# FASCICULE DE BREVET EUROPEEN

(11) **EP 1 142 460 B1**
(45) Date de publication et mention de la délivrance du brevet: **27.10.2004**
(21) Numéro de dépôt: 98960987.0
(22) Date de dépôt: 30.12.1998
(51) Int. Cl.: H05K 7/20

(54) **MODULE ELECTRONIQUE COMPORTANT DES ELEMENTS DE REFROIDISSEMENT DE COMPOSANTS ELECTRONIQUES**
ELEKTRONISCHE BAUGRUPPE MIT KÜHLELEMENTEN FÜR ELEKTRONISCHE BAUELEMENTE
ELECTRONIC MODULE CONTAINING COOLING ELEMENTS FOR ELECTRONIC COMPONENTS

(43) Date de publication de la demande: 10.10.2001
(73) Titulaire: Acqiris SA, 1228 Plan-les-Ouates (CH)
(72) Inventeur: VITTET, Jean-Pierre, CH-1233 Lully (CH); GOUMAZ Jean-François, CH-1208 Genève (CH)
(74) Mandataire: Saam, Christophe
(86) Numéro de dépôt international: PCT/CH1998/000563
(87) Numéro de publication internationale: WO 2000/041448

(56) Documents cités:
- EP-A- 0 369 115
- US-A- 4 665 467
- US-A- 4 753 287

## Description

La présente invention concerne un module électronique, notamment un module électronique comportant des composants électroniques et des éléments de refroidissement de ces composants électroniques. La présente invention concerne en particulier, mais pas exclusivement, un module électronique pour l'acquisition de données à haute fréquence et comprenant plusieurs canaux, chaque canal comprenant un convertisseur analogique-numérique à haute fréquence, ainsi que des éléments de refroidissement de ces convertisseurs.

On connaît de nombreux types de systèmes d'acquisition de données, par exemple des enregistreurs transitoires et des oscilloscopes numériques, dans lesquels il est nécessaire de convertir un ou plusieurs signaux analogiques en un ou plusieurs signaux numériques aptes à être mémorisés dans une mémoire numérique et traités par un processeur numérique. Depuis quelques années, on a vu également apparaître des systèmes d'acquisitions modulaires, comportant généralement un châssis dans lequel différents modules d'acquisition peuvent être insérés parallèlement dans des alvéoles, généralement désignées par leur appellation anglo-saxonne de slot. Chaque module comporte des moyens de connexion permettant de l'insérer et de le connecter de manière amovible dans le système, ainsi que généralement un ou plusieurs canaux d'acquisition permettant de numériser les signaux d'entrée observés. On connaît par exemple des modules d'acquisition conformes au standard PCI, Compact PCI, VXI ou PXI définissant les caractéristiques mécaniques et électriques des moyens de connexion entre modules. La présente invention s'applique en particulier aux modules de ce type.

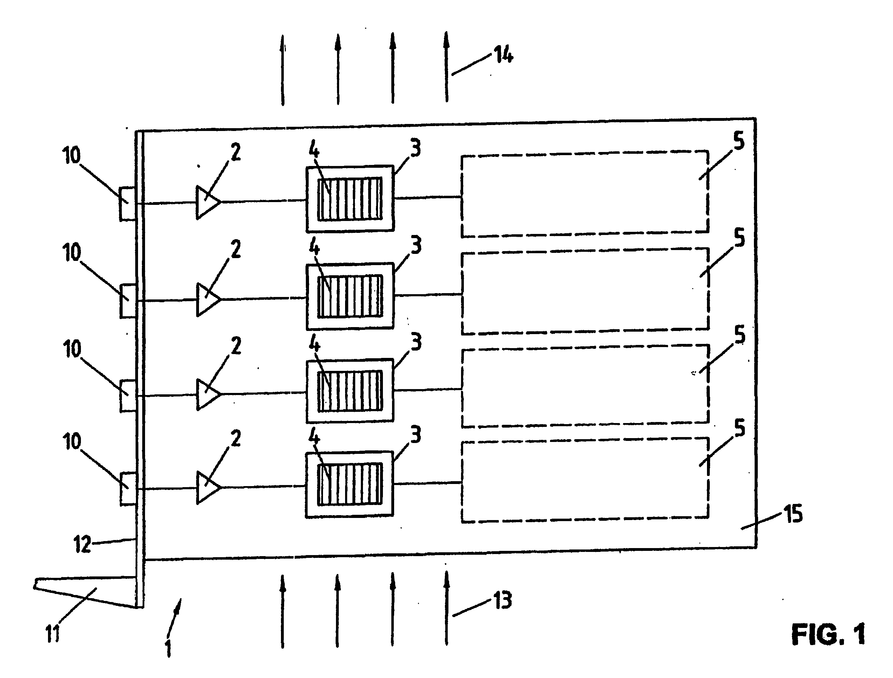

La figure 1 illustre de manière schématique un module d'acquisition selon l'art antérieur. Sur une carte de circuit imprimé 15 sont assemblés divers composants 2, 3, 5. Le module 1 est destiné à être enfiché dans des slots adaptés d'une carte mère non représentée, au moyens de connecteurs non représentés sur le bord inférieur ou arrière de la carte. Le module est muni d'une plaque frontale 12 munie d'un organe de préhension 11 ainsi que d'un nombre de connecteurs, par exemple des connecteurs BNC, correspondant au nombre de canaux du module. Un signal d'entrée peut être fourni à chaque canal au moyen de ces connecteurs.

Chaque canal comporte de manière générale un amplificateur d'entrée 2, un convertisseur analogique-numérique 3 ainsi qu'un circuit 5 de traitement et de mémorisation du signal numérique délivré non détaillé. Le signal ainsi traité est ensuite fourni à un microprocesseur non représenté apte à recevoir et à traiter les signaux fournis par différents canaux et sur différents modules.

Les convertisseurs analogiques-numériques 3 doivent, en vertu du principe de Nyquist, travailler à une fréquence d'échantillonnage double de la fréquence du signal à échantillonner afin de fournir une représentation numérique correcte du signal. Dans le cas de signaux à très haute fréquence, par exemple de signaux à plusieurs centaines de mégahertz, les convertisseurs 3 fonctionnent donc également à très grande vitesse et dégagent ainsi une énergie calorifique importante qui doit être évacuée.

Dans l'art antérieur, la chaleur dégagée par chaque convertisseur analogique-numérique est généralement évacuée au moyen d'un radiateur collé ou fixé sur la face supérieure du convertisseur. De l'air froid 13 est en outre parfois insufflé verticalement sur les radiateurs.

Les convertisseurs 3 sont des composants occupant une surface relativement importante sur la carte 15 du module, en sorte que l'on adopte généralement la disposition indiquée sur la figure 1, c'est-à-dire que les convertisseurs sont placés côte à côte et l'un au-dessus de l'autre. Toutefois, avec cette disposition, la température de l'air près des convertisseurs supérieurs est plus élevée que la température de l'air près des convertisseurs inférieurs (dans le cas où l'air est insufflé par le bas). Des essais ont montré que la différence de température d'un convertisseur à l'autre peut s'élever à 10 degrés environ. Dans un module comprenant quatre convertisseurs à haute fréquence, on peut ainsi avoir une différence de plus de trente degrés entre la température de l'air insufflé 13 et la température de l'air chaud ressortant 14.

Le convertisseur analogique-numérique supérieur fonctionne donc dans des conditions plus défavorables que le convertisseur inférieur qui est mieux refroidi. Il en résulte un vieillissement plus rapide des convertisseurs supérieurs, ainsi que des conditions de fonctionnement différentes rendant par exemple une égalisation des signaux numériques fournis difficile.

Un but de la présente invention est donc de remédier à ces différents problèmes, et de fournir un module électronique amélioré par rapport aux modules de l'art antérieur.

Selon l'invention, ces buts sont atteints au moyen d'un module selon les caractéristiques de la revendication 1, des variantes préférentielles étant par ailleurs indiquées dans les revendications dépendantes.

En particulier, ces buts sont atteints en plaçant un couvercle de protection amovible au dessus de la carte PCB du module, recouvrant de préférence toute ou une partie substantielle de la carte, et utilisé également comme radiateur pour évacuer la chaleur dissipée par les composants électroniques. Le couvercle peut être fabriqué à partir d'une simple tôle lisse ou profilée, découpée et éventuellement repliée. Un pont thermique est établi entre le couverde et les composants à refroidir. Le pont thermique comprend au moins un élément lié au couvercle, de préférence un élément compressible apte à s'adapter à l'épaisseur des composants, par exemple un piston appuyé par un ressort sur les composants à refroidir. Le piston est de préférence monté dans un support de piston lié au couvercle ; de préférence, plusieurs pistons, appuyés contre différents composants sur la même carte, sont montés dans un même support de piston, permettant ainsi d'uniformiser la température des différents composants, par exemple de différents convertisseurs analogiques-numériques dans un système d'acquisition.

Le couvercle, le support de piston et les pistons sont de préférence réalisés dans des matériau à très basse résistance thermique. La surface de contact entre les pistons et le support de piston est de préférence maximisée, afin de favoriser les échanges thermiques entre pistons et support de piston ; dans ce but, les pistons auront par exemple au moins une portion de profil conique.

Bien que l'invention s'applique particulièrement bien au refroidissement de convertisseurs analogiques-numériques dans un système d'acquisition à haute fréquence, l'homme du métier comprendra que l'invention peut aussi être appliquée au refroidissement de n'importe quel type de composants dégageant une chaleur importante dans n'importe quel type de module électronique - par exemple aussi au refroidissement de microprocesseurs ou de processeurs de traitement de signal.

Par module, il est nécessaire de comprendre dans la présente demande et dans les revendications n'importe quel type de module électronique, en particulier n'importe quel type de module apte à être enfiché dans un slot d'une carte mère d'un système de traitement électronique.

Il est déjà connu dans l'art antérieur d'utiliser un couvercle au-dessus de composants électroniques comme radiateur. Des solutions de ce type sont décrites dans les documents de brevet US4'235'283, US5'177'667, US5'228'502, US5'394'229, EP-B1-0'079'424, EP-B1-0'097'157, EP-B1-0'111'709, EP-B1-0'369'115, EP-B1-0552'787 ou EP-A1-673'064 par exemple. Aucune de ces solutions n'est toutefois adaptée au refroidissement par circulation d'air d'un module de grande dimension (environ 300 cm² dans un mode de réalisation préférentiel de l'invention), formé à partir d'une carte de circuit imprimé destinée à être enfichée de manière amovible dans les slots d'un système d'acquisition de données. Par ailleurs, ces solutions utilisent souvent des couvercles de forme complexe qui ne peuvent pas être usinés de manière simple à partir d'une simple tôle lisse ou profilée. Enfin, dans la plupart de ces documents, les composants électroniques sont cloisonnés par le couvercle, c'est-à-dire que chaque élément se trouve dans un compartiment défini par la forme du couvercle. Il n'est donc généralement pas possible d'insuffler de l'air entre le couvercle et la carte pour refroidir les composants; lorsqu'un interstice subsiste parfois entre le couvercle et la carte, cet interstice ne permet généralement pas de souffler de l'air sur toute la hauteur des composants, en sorte que cet air ne peut refroidir que la base des composants électroniques mais pas la partie supérieure dans laquelle se trouve généralement l'élément semiconducteur. Par ailleurs, chaque composant étant logé dans un espace cloisonné avec peu de circulation d'air entre composants, il est difficile d'uniformiser la température de composants électroniques, par exemple de convertisseurs analogiques-numériques devant fonctionner à des températures aussi proches que possible.

Par ailleurs, ces solutions sont généralement uniquement adaptés à des puces montées en flip-chip; les solutions choisies ne peuvent cependant pas être transposées au cas de composants habituels, par exemple BGA, montés sur une carte imprimée standard.

L'invention sera mieux comprise à l'aide de la description, donnée à titre d'exemple et illustrée par les figures qui montrent :
La figure 1 une vue schématique d'un module d'acquisition selon l'art antérieur, tel que commenté ci-dessus.
La figure 2 une vue en perspective et partiellement en transparence d'un module selon la présente invention.
La figure 3 une vue en perspective de dessous d'un couvercle de module selon la présente invention, muni d'un pont thermique selon la présente invention.
La figure 4 une vue en perspective de dessus d'un couvercle de module selon la présente invention, muni d'un pont thermique selon la présente invention représenté en éclaté.
La figure 5 une vue en perspective de dessous d'un couvercle de module selon la présente invention, muni d'un pont thermique selon la présente invention représenté en éclaté.

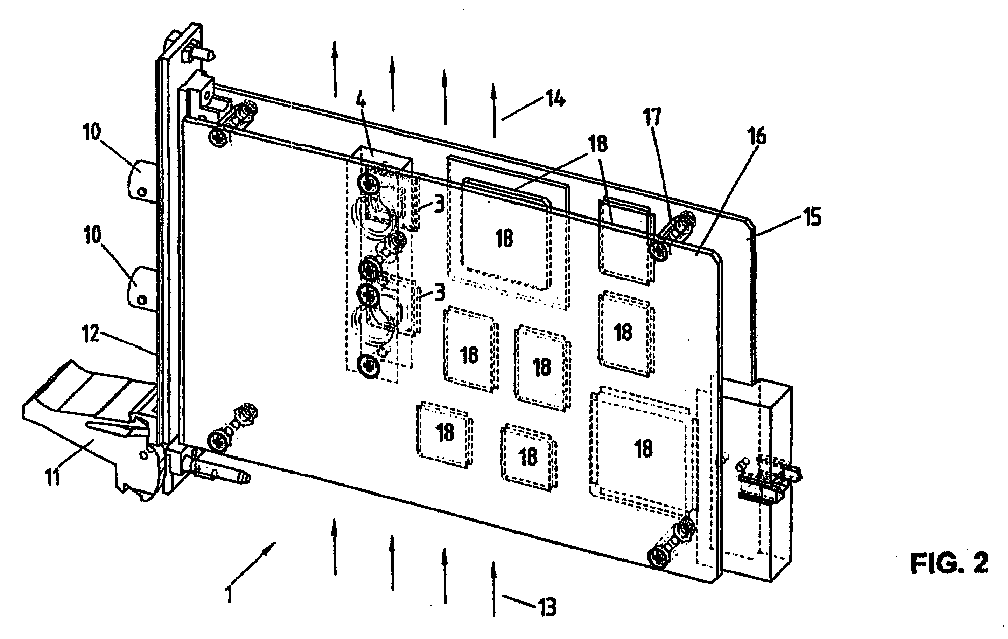

La figure 2 illustre en perspective à titre d'exemple un module d'acquisition 1 de données à deux canaux refroidi selon l'invention. Bien que tous les exemples illustrés représentent des modules d'acquisition à deux canaux, il est évident que l'invention s'applique aussi à des modules comprenant n'importe quel nombre de canaux. Le module 1 est principalement constitué par une carte de circuit imprimé 15 sur laquelle sont montés des composants 3 et 18. Dans cet exemple, le module est destiné à être enfiché dans les slots d'un système d'acquisition pouvant comprendre plusieurs modules. A cet effet, le module comprend des moyens de connexion sur un bord, de manière à ce que le module puisse être enfiché de manière amovible et connecté électriquement avec une carte mère (non représentée). La disposition des moyens de connexion est de préférence conforme au standard PCI, CompactPCI, VXI ou PXI, ou à un autre standard adapté à l'interconnexion de modules d'acquisition. Un panneau frontal 12 contient divers éléments de manipulation du module (non représentés) ainsi que des connecteurs BNC 10 pour les signaux analogiques d'entrée. Le module 1 peut être introduit ou retiré du système d'acquisition au moyen d'un organe de préhension 11. De l'air froid 13 peut être insufflé sur les composants 3, 18, de préférence par le bas, l'air réchauffé 14 s'échappant par le haut du module. L'air peut s'écouler autour de tous les composants 3, 18 ainsi que sur la surface supérieure des composants 3.

Selon l'invention, la carte 15 est recouverte par un couvercle de protection 16 protégeant dans cet exemple l'ensemble des composants 3, 18 de la carte et fixé dans cet exemple par des colonnettes vissées 17. Le couvercle 16 offre une protection mécanique aux composants 3, 18 et prévient les risques de destruction par choc électrostatique en cas de contact avec un utilisateur. Le couvercle n'est de préférence pas fermé sur les flancs du module, de manière à ce que de l'air puisse circuler entre la carte 15 et le couvercle 16. Selon l'invention, le couvercle permet en outre de dissiper la chaleur diffusée par au moins certains composants 3 du module, par exemple les convertisseurs analogiques-numériques. Le couvercle est de préférence formé à partir d'une simple tôle métallique lisse ou profilée et découpée aux dimensions de la carte 15, un ou plusieurs bords pouvant être éventuellement repliés.

Un pont thermique est établi entre les composants électroniques à refroidir 3 et le couvercle 16, au moyen d'un élément 4 solidairement lié au couvercle et venant en appui contre la face supérieure des composants 3. La résistance thermique du pont thermique est minimisée autant que possible de façon à améliorer le transfert de chaleur en direction du couvercle 16 qui agit ainsi comme un radiateur de grande dimension.

La hauteur des colonnettes 17 est de préférence prévue de manière à ce que le couvercle 16 ne soit pas en contact direct avec les composants 3, 18 les plus épais de la carte, et à ce que de l'air puisse également circuler entre le couvercle 16 et la carte d'un module enfiché dans un slot voisin.

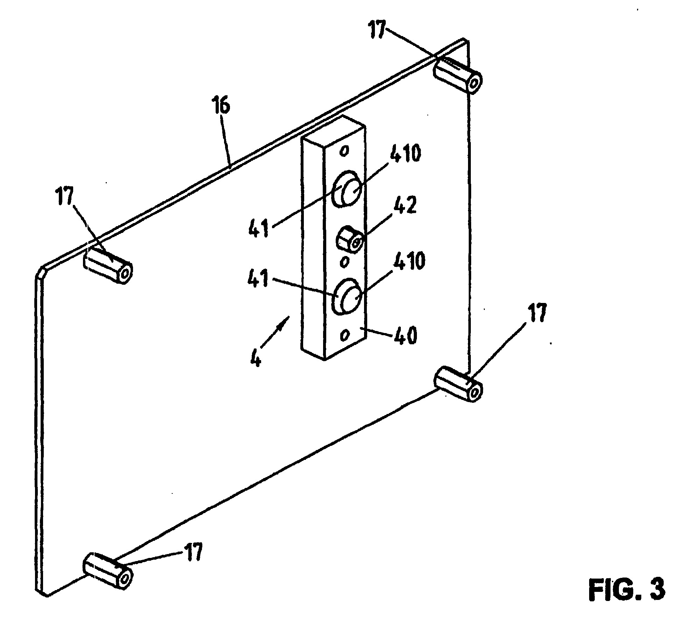

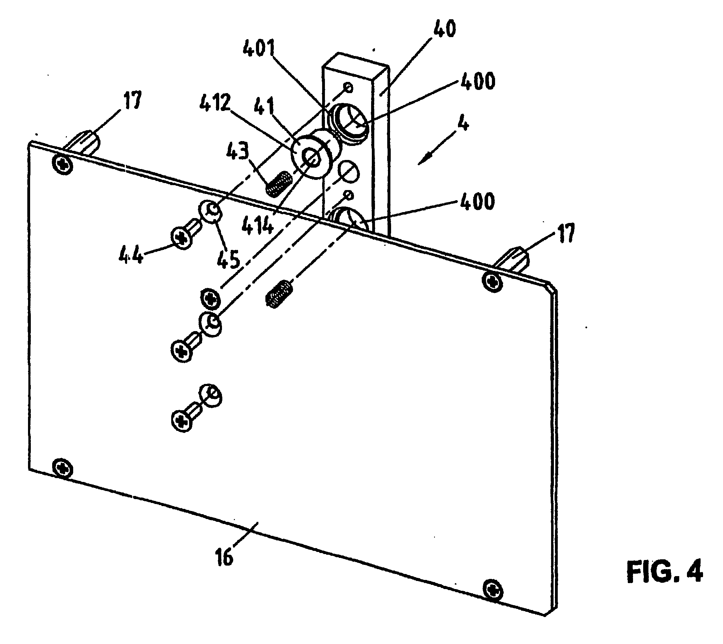

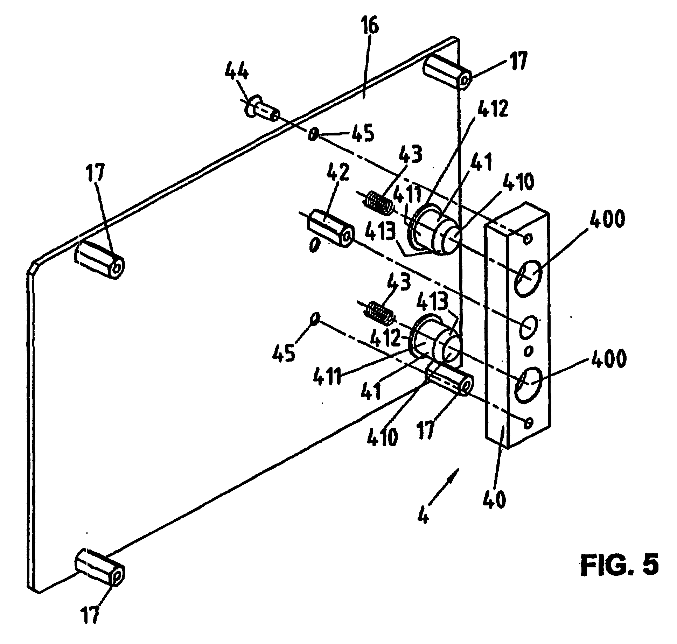

Nous allons maintenant décrire, à l'aide des figures 3 à 5, la structure du pont thermique 4 selon un exemple de réalisation préférentiel. Le pont thermique 4 comporte un support de piston 40 fixé par exemple au moyen de vis 44 au couvercle de protection, au dessus des composants à refroidir. Le couvercle est constitué par une simple plaque aux dimensions de la carte circuit imprimé 15 (environ 300 cm²); la seule modification à apporter au couvercle pour l'adapter à une autre disposition des composants électroniques sur la carte 15 consiste à modifier l'emplacement des trous 45 de passage des vis 44, afin de déplacer le support de piston 40.

Dans une variante, il est également possible de fixer le support 40 au moyen de clips ou de le sertir au couvercle.

Le support de piston 40 comporte une ou plusieurs ouvertures (ou cylindres) 400 dans lesquels les pistons 41 peuvent se déplacer longitudinalement. Les pistons sont munis d'un rebord annulaire 412 correspondant à une gorge annulaire 401 dans les ouvertures 400, en sorte que le piston ne peut pas sortir de l'ouverture 400 lorsque le support de piston 40 est vissé sur le couvercle 16. Un élément compressible, de préférence un ressort spirale 43, est enfiché dans une ouverture 414 dans chaque piston de manière à l'éloigner du couvercle 16 ; la force du ressort est choisie de manière à ce que la tête de piston 410 appuie avec une force de 10 Newtons environ sur le composant à refroidir 3, permettant ainsi un bon contact et un bon transfert thermique sans risque de destruction du composant.

La tête du piston a un diamètre correspondant de préférence sensiblement à celui de la face supérieure du composant à refroidir ; une section de la tête non circulaire, par exemple carrée ou rectangulaire, peut aussi être adoptée. De manière préférentiel, la tête du piston comporte une portion centrale proéminente, (non illustrée) de diamètre inférieur à celui de la tête de piston et d'une hauteur de quelques dixièmes de millimètres, afin d'assurer un contact de qualité entre le piston et précisément la portion du composant dans laquelle se trouve la source thermique. Il est aussi possible d'utiliser une tête de piston légèrement convexe pour garantir un contact excellent même en cas de défaut d'alignement du composant à refroidir. Afin d'améliorer le transfert thermique entre ces deux composants, on enduira préférablement la surface de contact avec un film de pâte thermoconductrice. La chaleur dégagée par les composants à refroidir est ainsi transmise avec une résistance thermique minimale au piston, en sorte que la différence de température entre le boîtier du composant 3 et le piston 41 n'est par exemple que de 3 à 6 degrés environ.

Afin d'accroître la surface d'échange thermique entre le piston 41 et le support de piston 40, on utilisera de préférence une section des pistons et des ouvertures 400 aussi grande que possible ; dans ce but, les pistons 412 sont munis d'une portion tronconique 413 faisant le lien entre la tête 410 du piston en contact avec le composant électronique 3 et la portion 411 du piston en contact avec le support de piston 40. Une graisse au silicone, lubrifiante et permettant un coulissement du piston dans l'ouverture, est de préférence en outre utilisée pour améliorer le transfert thermique entre les pistons et le support.

Plusieurs pistons 41 peuvent être placés dans le même support de piston 40, afin d'uniformiser la température entre les différents composants électroniques en contact avec ces différents pistons. Les ressorts 43 permettent au piston de s'adapter aux variations d'épaisseur entre ces divers composants. Dans le cas de composants de dimensions très différentes, il est aussi possible d'utiliser des pistons de longueur et/ou de diamètre différents dans le même module 1, voire dans le même support de piston 40. La longueur ou la force des ressorts 43 peut aussi être adaptée aux composants à refroidir. Il est aussi naturellement possible de visser plusieurs supports de piston 40 sur le même couvercle 16.

Afin de garantir un plaquage efficace des têtes de piston 410 sur les composants 3, le support de piston 40 sera de préférence fixé ou vissé par une colonnette 42 directement sur la carte circuit imprimé 15 à proximité des composants à refroidir 3. Il est aussi possible de fixer directement le couvercle 16 sur la plaque 15 à proximité des composants 3.

On fabriquera les pistons 41, le support de piston 40 et le couvercle 16 dans un ou différents matériaux bon conducteurs thermiques, de préférence en métal, par exemple en aluminium. Le ressort 43 lui-même peut participer au transfert thermique entre le piston et le couvercle ; on le choisira de préférence en un métal bon conducteur thermique. Les pistons et le support de piston sont de préférence éloxés de noir ; le couvercle est de préférence également noir ou de couleur sombre. Afin d'augmenter la surface de contact entre le couvercle et l'air environnant, au moins une portion du couvercle pourra être rugueuse, profilée ou du moins non-lisse. On injectera par ailleurs de l'air froid, par exemple à une vitesse comprise entre 1 et 3 mètres par seconde, sur le couvercle, par exemple entre la plaque 15 et le couvercle de protection 16 ou sur les deux faces de ce dernier, afin de le refroidir plus efficacement.

Dans la mesure du choix disponible, on utilisera de préférence des composants à refroidir 3 pourvus d'un boîtier permettant de dissiper une grande part de la chaleur émise par la face supérieure mise en contact avec la tête de piston. On utilisera par exemple de préférence des composants électroniques 3 avec des boîtiers à cavité inversée de type BGA, ou des boîtiers QFP (quad flat pack) ou BGA avec puce montée en flip-chip, éventuellement munis de composants en surface sur la surface supérieure du boîtier.

## Revendications

1. Module électronique (1) comprenant :
une carte d'interconnexion (15) comprenant un connecteur sur un bord, de manière à ce que ladite carte puisse être enfichée de manière amovible et connectée électriquement avec une carte-mère,
différents composants électroniques (3, 18) montés sur au moins une face de ladite carte,
un couvercle de protection (16) monté de manière amovible en regard de ladite face et recouvrant ladite face sans cloisonner lesdits composants électroniques (3, 18), de manière à ce que de l'air puisse circuler autour desdits composants électroniques, ledit couvercle étant fabriqué à partir d'une tôle,
**caractérisé par** au moins un élément (4) solidairement lié au couvercle de protection (16) et venant en appui contre la face supérieure d'au moins un dit composant électronique (3), de manière à établir un pont thermique entre ledit composant électronique et ledit couverde de protection.

2. Module électronique selon la revendication 1, dans lequel l'épaisseur dudit élément (4) en appui contre la face supérieure d'au moins un dit composant électronique peut être adaptée à l'épaisseur dudit composant électronique (3).

3. Module électronique selon la revendication précédente, dans lequel ledit élément (4) est compressible.

4. Module électronique selon la revendication précédente, dans lequel ledit élément (4) comporte un piston (41) et un ressort (43) pour appuyer ledit piston contre une face du composant électronique (3) à refroidir, ledit piston et ledit ressort étant montés dans un support de piston (40) solidairement lié au couvercle de protection (16).

5. Module selon la revendication précédente, dans lequel ledit support de piston (40) est fixé de manière amovible au couvercle de protection (16).

6. Module électronique selon la revendication précédente, dans lequel ledit support de piston (40) est vissé sur ledit couvercle (16).

7. Module électronique selon la revendication précédente, dans lequel ledit support de piston (40) est en outre vissé sur ladite carte d'interconnexion (15).

8. Module selon l'une des revendications 4 à 7, dans lequel le diamètre de la portion (410) du piston (41) en contact avec le composant électronique (3) à refroidir est inférieur au diamètre de la portion (411) du piston en contact avec le support de piston (40).

9. Module électronique selon l'une des revendications 6 ou 7, dans lequel plusieurs pistons (41) et plusieurs ressorts (43) sont montés dans le même support de piston (40) solidairement lié au couvercle de protection (16).

10. Module électronique selon l'une des revendications 4 à 9, dans lequel plusieurs desdits éléments (4) sont montés sur le même couvercle de protection (16).

11. Module électronique selon l'une des revendications précédentes, dans lequel un premier composant thermoconducteur est disposé entre ledit piston (41) et ladite face supérieure d'au moins un dit composant électronique (3).

12. Module électronique selon l'une des revendications 4 à 11, dans lequel un second composant thermoconducteur et de lubrification est disposé entre ledit piston (41) et ledit support de piston (40).

13. Module électronique selon l'une des revendications 4 à 12, dans lequel ledit piston (41) est éloxé noir.

14. Module électronique selon l'une des revendications 4 à 13, dans lequel ledit support de piston (40) est éloxé noir.

15. Module électronique selon l'une des revendications précédentes, dans lequel ledit couvercle (16) est noir.

16. Module électronique selon la revendication précédente, dans lequel la surface du dit couvercle (16) est non lisse.

17. Module électronique selon l'une des revendications précédentes, dans lequel au moins un desdits composants électroniques (3) est constitué par un circuit monté dans un boîtier BGA à cavité inversée.

18. Module électronique selon l'une des revendications précédentes, dans lequel au moins un desdits composants électroniques (3) est constitué par un circuit monté en flip-chip sur dans un boîtier BGA

19. Module électronique selon l'une des revendications précédentes, dans lequel au moins un desdits composants électroniques (3) est constitué par un circuit monté dans un boîtier QFP.

20. Module électronique selon l'une des revendications 4 à 19, comprenant un système d'acquisition de données à haute fréquence et à plusieurs canaux, chaque canal comprenant un convertisseur analogique-numérique (3), chaque convertisseur (3) étant en appui avec un dit piston (41), tous les pistons (41) destinés à refroidir lesdits convertisseurs (3) étant montés dans le même support de piston (40).

## Claims

1. Electronic module (1) including:
an interconnection board (15) including a connector on one side, so that said board can be removably inserted and electrically connected with a motherboard,
different electronic components (3, 18) mounted on at least one side of said board,
a protective cover (16) removably mounted above said side and covering said side without partitioning said electronic components (3, 18), so that the air can circulate around said electronic components, said cover being made from a sheet,
**characterized by** at least one element (4) integrally connected with the protective cover (16) and pressing against the upper side of at least one of said electronic components (3), so as to establish a thermal bridge between said electronic component and said protective cover.

2. Electronic module according to claim 1, wherein the thickness of said element (4) pressing against the upper side of at least one of said electronic components can be adapted to the thickness of said electronic component (3).

3. Electronic module according to the preceding claim, wherein said element (4) is compressible.

4. Electronic module according to the preceding claim, wherein said element (4) includes a piston (41) and a spring (43) for pressing said piston against one side of the electronic component (3) to be cooled, said piston and said spring being mounted in a piston carrier (40) integrally connected with the protective cover (16).

5. Module according to the preceding claim, wherein said piston carrier (40) is removably fastened to the protective cover (16).

6. Electronic module according to the preceding claim, wherein said piston carrier (40) is screwed on said cover (16).

7. Electronic module according to the preceding claim, wherein said piston carrier (40) is further screwed on said interconnection board (15).

8. Module according to one of the claims 4 to 7, wherein the diameter of the portion (410) of the piston (41) in contact with the electronic component (3) to be cooled is smaller than the diameter of the portion (411) of the piston in contact with the piston carrier (40).

9. Electronic module according to one of the claims 6 or 7, wherein several pistons (41) and several springs (43) are mounted in the same piston carrier (40) integrally connected with the protective cover (16).

10. Electronic module according to one of the claims 4 to 9, wherein several of said elements (4) are mounted on the same protective cover (16).

11. Electronic module according to one of the claims 4 to 9, wherein a first heat-conductive component is placed between said piston (41) and said upper side of at least one of said electronic components (3).

12. Electronic module according to one of the claims 4 to 11, wherein a second heat-conductive and lubricating component is placed between said piston (41) and said piston carrier (40).

13. Electronic module according to one of the claims 4 to 12, wherein said piston (41) is black-eloxed.

14. Electronic module according to one of the claims 4 to 13, wherein said piston carrier (40) is black-eloxed.

15. Electronic module according to one of the preceding claims, wherein said cover (16) is black.

16. Electronic module according to the preceding claim, wherein the surface of said cover (16) is not flat.

17. Electronic module according to one of the preceding claims, wherein at least one of said electronic components (3) is constituted of a circuit mounted in a BGA housing with inverted cavity.

18. Electronic module according to one of the preceding claims, wherein at least one of said electronic components (3) is constituted of a circuit mounted in flip-chip fashion on a BGA housing.

19. Electronic module according to one of the preceding claims, wherein at least one of said electronic components (3) is constituted of a circuit mounted in a QFP housing.

20. Electronic module according to one of the claims 4 to 19, comprising a high frequency data acquisition system with several channels, whereas each channel includes an analog-to-digital converter (3), whereas each converter (3) rests against one of said pistons (41), whereas all the pistons (41) designed to cool said converters (3) are mounted in the same piston carrier (40).

## Patentansprüche

1. Elektronisches Modul (1), umfassend:
eine Verbindungskarte (15) mit einem Verbindungsstück auf einer Seite, so dass besagte Karte in abnehmbarer Weise eingesteckt und mit einer Mutterkarte elektrisch verbunden werden kann,
verschiedene elektronische Komponenten (3, 18), welche auf mindestens einer Seite besagter Karte montiert sind,
einen Schutzdeckel (16), welcher in abnehmbarer Weise gegenüber besagter Seite montiert ist und besagte Seite bedeckt, ohne besagte elektronische Komponenten (3, 18) abzutrennen, so dass Luft um besagte elektronische Komponente zirkulieren kann, wobei besagter Deckel aus einem Blech hergestellt wird,
**gekennzeichnet durch** mindestens ein mit dem Schutzdeckel (16) solidarisch verbundenes Element (4), das gegen die Oberseite von mindestens einer elektronischen Komponente (3) ruht, um eine thermische Brücke zwischen besagter elektronischen Komponente und besagtem Schutzdeckel herzustellen.

2. Elektronisches Modul gemäss Anspruch 1, in welchem die Dicke des besagten gegen die Oberseite mindestens einer elektronischen Komponente ruhenden Elements (4) an die Dicke der besagten elektronischen Komponente (3) angepasst werden kann.

3. Elektronisches Modul gemäss dem vorhergehenden Anspruch, in welchem besagtes Element (4) komprimierbar ist.

4. Elektronisches Modul gemäss dem vorhergehenden Anspruch, in welchem besagtes Element (4) einen Kolben (41) und eine Feder (43) umfasst, um besagten Kolben gegen eine Seite der zu kühlenden elektronischen Komponente (3) zu drücken, wobei besagter Kolben und besagte Feder in einem Kolbenträger (40) montiert sind, der mit dem Schutzdeckel (16) solidarisch verbunden ist.

5. Modul gemäss dem vorhergehenden Anspruch, in welchem besagter Kolbenträger (40) in abnehmbarer Weise auf dem Schutzdeckel (16) angebracht ist.

6. Elektronisches Modul gemäss dem vorhergehenden Anspruch, in welchem besagter Kolbenträger (40) ferner auf besagtem Deckel (16) angeschraubt ist.

7. Elektronisches Modul gemäss dem vorhergehenden Anspruch, in welchem besagter Kolbenträger (40) ferner auf besagter Verbindungskarte (15) angeschraubt ist.

8. Modul gemäss einem der Ansprüche 4 bis 7, in welchem der Durchmesser der Portion (410) des Kolbens (41) im Kontakt mit der zu kühlenden elektronischen Komponente (3) kleiner als der Durchmesser der Portion (411) des Kolbens in Kontakt mit dem Kolbenträger (40) ist.

9. Elektronisches Modul gemäss einem der Ansprüche 6 oder 7, in welchem mehrere Kolben (41) und mehrere Federn (43) im gleichen mit dem Schutzdeckel (16) solidarisch verbundenen Kolbenträger (40) montiert sind.

10. Elektronisches Modul gemäss einem der Ansprüche 4 bis 9, in welchem mehrere besagter Elemente (4) auf dem gleichen Schutzdeckel (16) montiert sind.

11. Elektronisches Modul gemäss einem der vorhergehenden Ansprüche, in welchem eine erste wärmeleitende Komponente zwischen besagtem Kolben (41) und besagter Oberseite von mindestens einer elektronischen Komponente (3) angeordnet ist.

12. Elektronisches Modul gemäss einem der Ansprüche 4 bis 11, in welchem eine zweite wärmeleitende und schmierende Komponente zwischen besagtem Kolben (41) und besagtem Kolbenträger (40) angeordnet ist.

13. Elektronisches Modul gemäss einem der Ansprüche 4 bis 12, in welchem besagter Kolben (41) schwarz-eloxiert ist.

14. Elektronisches Modul gemäss einem der Ansprüche 4 bis 13, in welchem besagter Kolbenträger (40) schwarz-eloxiert ist.

15. Elektronisches Modul gemäss einem der vorhergehenden Ansprüche, in welchem besagter Deckel (16) schwarz ist.

16. Elektronisches Modul gemäss dem vorhergehenden Ansprüch, in welchem die Oberfläche besagtes Deckels (16) nicht glatt ist.

17. Elektronisches Modul gemäss einem der vorhergehenden Ansprüche, in welchem mindestens eine besagter elektronischer Komponenten (3) aus einem Schaltkreis besteht, der in einem BGA-Gehäuse mit umgekehrter Vertiefung montiert ist.

18. Elektronisches Modul gemäss einem der vorhergehenden Ansprüche, in welchem mindestens eine besagter elektronischen Komponente (3) aus einem Schaltkreis besteht, der in flip-chip in einem BGA-Gehäuse montiert ist.

19. Elektronisches Modul gemäss einem der vorhergehenden Ansprüche, in welchem mindestens eine besagter elektronischen Komponente (3) aus einem Schaltkreis besteht, der in einem QFP-Gehäuse montiert ist.

20. Elektronisches Modul gemäss einem der Ansprüche 4 bis 19, umfassend ein hochfrequentes und mehrkanaliges Datenerfassungssystem, wobei jeder Kanal einen analog-digital Konverter (3) aufweist, wobei jeder Konverter (3) mit einem besagten Kolben (41) ruht, wobei alle Kolben (41) dazu vorgesehen sind, die besagten im gleichen Kolbenträger (40) montierten Konverter (3) abzukühlen.
